# EUROPEAN PATENT APPLICATION

(11) **EP 1 659 633 A2**
(43) Date of publication of application: **24.05.2006**
(21) Application number: 05110854.6
(22) Date of filing: 17.11.2005
(51) Int. Cl.: H01L 27/32

(54) **Flat panel display and its method of fabrication**

(30) Priority: 18.11.2004 KR 2004094512
(71) Applicant: Samsung SDI Co., Ltd., Suwon-si Gyeonggi-do (KR)
(72) Inventor: Shin, Hyun-Soo c/o Samsung SDI Co., Ltd., Gyeonggi-do (KR); Koo, Jae-Bon c/o Samsung SDI Co., Ltd., Gyeonggi-do (KR); Mo, Yeon-Gon c/o Samsung SDI Co., Ltd., Gyeonggi-do (KR)
(74) Representative: Hengelhaupt, Jürgen

(57) **Abstract**

A flat panel display device which can prevent line defects and voltage drops using a conductive substrate formed of metal foil as a power supply layer includes: a conductive substrate (300); a first insulating layer (305) formed on one side of the substrate and having a contact hole exposing a part of the conductive substrate; a Thin Film Transistor (TFT) having a semiconductor layer (310) formed on the first insulating layer, a gate electrode (325), and source and drain electrodes (342,345); and a display element having a pixel electrode (360) connected to one of the source and drain electrodes of the TFT. The other of the source and drain electrodes of the TFT is electrically connected to the conductive substrate (300) via the contact hole (337).

## Description

### CLAIM OF PRIORITY

This application makes reference to, incorporates the same herein, and claims all benefits accruing under 35 U.S.C. §119 from an application for *ORGANIC LIGHT EMITTING DEVICE AND METHOD FOR FABRICATING THE SAME* earlier filled in the Korean Intellectual Property Office on 18 November 2004 and there duly assigned Serial No. 10-2004-0094512.

### BACKGROUND OF THE INVENTION

### Field of the Invention

The present invention relates to a flat panel display device, and more particularly, to a flexible Organic Electro-Luminescent Display (OELD) using a metal foil substrate as a power supply layer and its method of fabrication.

### Description of the Related Art

Organic Electro-Luminescent Display (OELD) elements are self-emission display elements in which light is emitted from an emission layer according to voltages supplied to two electrodes between which the emission layer is interposed. OELD elements have advantages such as wider view-angle than Liquid Crystal Display (LCD) elements, high contrast and a fast response speed and thus, are being considered as next-generation flat panel display elements.

An OELD apparatus includes a gate line, a data line, a power supply line, and a pixel arranged in a pixel region. The pixel includes a switching Thin Film Transistor (TFT), a capacitor, a driving Thin Film Transistor (TFT), and an organic Electro-Luminescent (EL) element having a pixel electrode.

The switching TFT includes a semiconductor layer, a gate electrode, and source and drain electrodes each being respectively connected to the semiconductor layer via contact holes 64 The capacitor includes a lower electrode and an upper electrode, which are connected to the drain electrode of the switching TFT via a contact hole.

The driving TFT includes a semiconductor layer, a gate electrode, and a source electrode and a drain electrode each being respectively connected to the semiconductor layer via contact holes. The organic EL element includes an anode electrode which is a pixel electrode connected to the driving TFT and exposed via an opening.

A semiconductor layer having source and drain regions is formed on a glass substrate, and a lower electrode of a capacitor and a gate electrode are formed on a gate insulating layer. Source and drain electrodes that contact source and drain regions are formed on an Inter-Level Dielectric (ILD) layer.

An anode electrode, which is a pixel electrode connected to the drain electrode of the source and drain electrodes through a via hole, is formed on a protective layer. A pixel isolation layer includes an opening through which the anode electrode is exposed, an organic layer formed on the anode electrode in the opening, and a cathode electrode formed on the glass substrate.

The OELD described above forms a gate line and the capacitor lower electrode when forming the gate electrode and forms a data line, a power supply line, and a capacitor upper electrode when forming the source and drain electrodes.

Since two signal lines exist on one layer, the power supply line is patterned to be formed in a line shape. Thus, when a power supply voltage is supplied to a pixel via the power supply line, due to voltage drop caused by the power supply line formed in a line shape, the power supply voltage supplied to a pixel according to the arrangement position of the pixel becomes non-uniform. As a result, non-uniform brightness occurs and image quality is degraded.

In addition, when two adjacent signal lines are arranged on one layer, due to extraneous particles formed during fabrication, a short between the data line and the power supply line can occur.

A technology for forming an additional power supply layer to prevent line defects and voltage drop has been proposed. Korean Laid-Open Patent Publication No. 2003-0049385 discusses an OELD having a front emission structure in which a power supply layer for supplying a power supply voltage is additionally formed on a substrate. An electrode is formed on the entire surface of a glass substrate and a power supply layer is supplied to each pixel via the electrode formed on the entire surface of the glass substrate. However, an additional process of forming an additional power supply layer must be added to the entire process.

### SUMMARY OF THE INVENTION

The present invention provides a flat panel display device which can prevent line defects and voltage drops using a substrate formed of metal foil as a power supply layer and its method of fabrication.

According to one aspect of the present invention, a flat panel display device is provided comprising: a conductive substrate; a first insulating layer arranged on one side of the conductive substrate and having a contact hole exposing a part of the substrate; a Thin Film Transistor (TFT) having a semiconductor layer arranged on the first insulating layer, a gate electrode, and source and drain electrodes; and a display element having a pixel electrode connected to one of the source and drain electrodes of the TFT; wherein the other of the source and drain electrodes of the TFT is electrically connected to the conductive substrate via the contact hole.

The conductive substrate preferably comprises a flexible substrate of a metal foil.

The first insulating layer preferably comprises a buffer layer.

The display element preferably comprises an organic electroluminescent element. The organic electroluminescent element includes a lower electrode being the pixel electrode; a second insulating layer having an opening exposing a part of the lower electrode; an organic layer arranged on the lower electrode in the opening; and an upper electrode arranged on the conductive substrate.

A thickness of the second insulating layer is preferably equal to or greater than 0.5 µ*m*.

The flat panel display device preferably further comprises a third insulating layer arranged the other side of the conductive substrate to insulate the other side of the conductive substrate.

The TFT preferably comprises a silicon TFT having a semiconductor layer of a silicon film.

The TFT alternatively preferably comprises an organic TFT having an organic semiconductor layer.

According to another aspect of the present invention, a flat panel display device is provided comprising: a conductive substrate having a plurality of pixel regions; a first insulating layer arranged on the conductive substrate and having a plurality of contact holes respectively exposing parts of the pixel regions; a plurality of Thin Film Transistors (TFTs) arranged on the first insulating layer in each of the pixel regions and having island shaped source and drain electrodes; and a display element arranged on the first insulating layer in each of the pixel regions and having a pixel electrode connected to one of the source and drain electrodes of the TFT; wherein the conductive substrate is connected to the other of the source and drain electrodes of each of the TFTs via each of the contact holes and is adapted to operate as a power supply layer to supply a power supply voltage to the TFTs.

The conductive substrate preferably comprises a flexible substrate of a metal foil.

The first insulating layer preferably comprises a buffer layer.

The display element preferably comprises an organic electroluminescent element.The organic electroluminescent element includes a lower electrode being the pixel electrode; a second insulating layer having an opening exposing a part of the lower electrode; an organic layer arranged on the lower electrode in the opening; and an upper electrode arranged on the conductive substrate.

A thickness of the second insulating layer is preferably equal to or greater than 0.5 µ*m*.

The flat panel display device preferably further comprises a third insulating layer arranged the other side of the conductive substrate to insulate the other side of the conductive substrate.

According to yet another aspect of the present invention, a method of fabricating a flat panel display device is provided, the method comprising: forming a first insulating layer on a conductive substrate; forming a semiconductor layer having source and drain regions and a gate electrode on the first insulating layer; forming a second insulating layer on the conductive substrate; etching the first insulating layer and the second insulating layer to form a first contact hole exposing parts of the source and drain regions of the semiconductor layer and a second contact hole exposing a part of the conductive substrate; forming source and drain electrodes to contact each of the source and drain regions of the semiconductor layer via the first contact hole; and forming a display element having a pixel electrode connected to one of the source and drain electrodes; wherein the other of the source and drain electrodes is electrically connected to the conductive substrate via the second contact hole.

The conductive substrate preferably comprises a flexible substrate formed of a metal foil.

Forming the first insulating layer preferably comprises forming a buffer layer and forming the second insulating layer comprises forming an InterLevel Dielectric (ILD) layer.

Forming the display element preferably comprises: forming a lower electrode being the pixel electrode; forming a third insulating layer having an opening exposing a part of the lower electrode; forming an organic layer on the lower electrode in the opening; and forming an upper electrode on the conductive substrate.

A thickness of the third insulating layer is preferably formed to be equal to or greater than 0.5 *µm*.

The method further preferably comprises forming a fourth insulating layer on the other side of the conductive substrate to insulate the other side of the conductive substrate.

### BRIEF DESCRIPTION OF THE DRAWINGS

A more complete appreciation of the present invention, and many of the attendant advantages thereof, will be readily apparent as the present invention becomes better understood by reference to the following detailed description when considered in conjunction with the accompanying drawings in which like reference symbols indicate the same or similar components, wherein:

FIG. 1 is a plan view of an OELD apparatus;

FIG. 2 is a cross-sectional view of the OELD of FIG. 1;

FIG. 3 is a plan view of an OELD according to an embodiment of the present invention;

FIG. 4 is a cross-sectional view of the OELD of FIG. 3;

FIG. 5 is a view of the relationship of a power supply layer to source and drain electrodes of the OELD of FIG. 3; and

FIG. 6 is a cross-sectional view of an OELD according to another embodiment of the present invention.

### DETAILED DESCRIPTION OF THE INVENTION

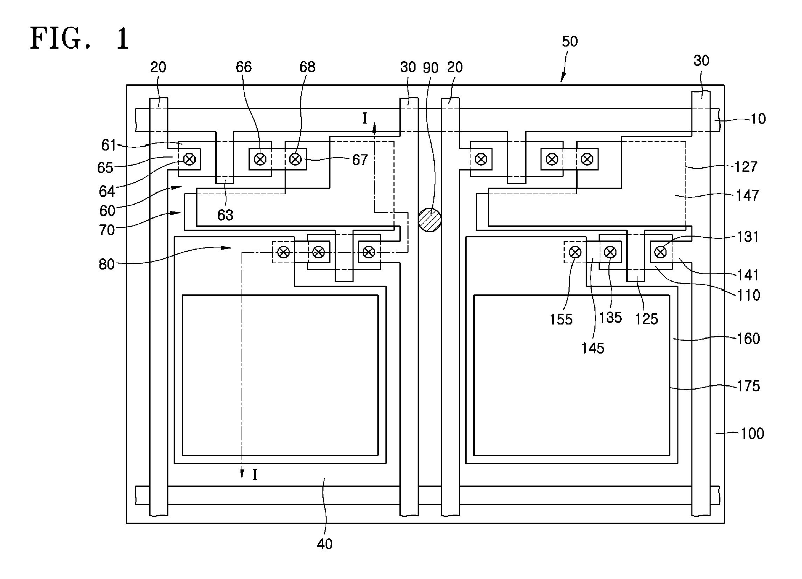

FIG. 1 is a plan view of an OELD apparatus. The OELD of FIG. 1 includes a gate line 10, a data line 20, a power supply line 30, and a pixel 50 arranged in a pixel region 40. The pixel 50 includes a switching Thin Film Transistor (TFT) 60, a capacitor 70, a driving Thin Film Transistor (TFT) 80, and an organic Electro-Luminescent (EL) element having a pixel electrode 160.

The switching TFT 60 includes a semiconductor layer 61, a gate electrode 63, and source and drain electrodes 65 and 67 each being respectively connected to the semiconductor layer 61 via contact holes 64 and 66. The capacitor 70 includes a lower electrode 127 and an upper electrode 147, which are connected to the drain electrode 67 of the switching TFT 60 via a contact hole 68.

The driving TFT 80 includes a semiconductor layer 110, a gate electrode 125, and a source electrode 141 and a drain electrode 145 each being respectively connected to the semiconductor layer 110 via contact holes 131 and 135. The organic EL element includes an anode electrode 160 which is a pixel electrode connected to the driving TFT 80 and exposed via an opening 175.

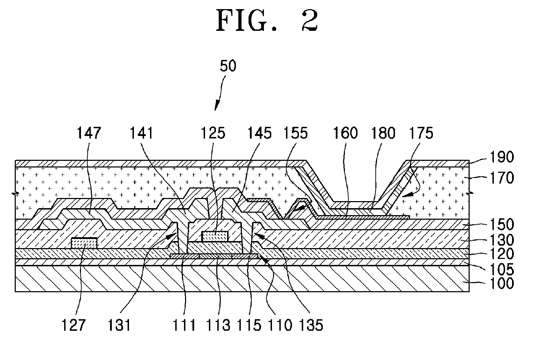

FIG. 2 is a cross-sectional view of the OELD taken along line I-I of FIG. 1. FIG. 2 shows only cross-sectional structures of an EL element, a driving TFT for driving the EL element, and a capacitor of the OELD.

Referring to FIG. 2, a semiconductor layer 110 having source and drain regions 111 and 115 is formed on a glass substrate 100, and a lower electrode 127 of a capacitor 70 and a gate electrode 125 are formed on a gate insulating layer 120. Source and drain electrodes 141 and 145 that contact source and drain regions 111 and 115 are formed on an Inter-Level Dielectric (ILD) layer 130.

An anode electrode 160, which is a pixel electrode connected to the drain electrode 145 of the source and drain electrodes 141 and 145 through a via hole 155, is formed on a protective layer 150. A pixel isolation layer 170 includes an opening 175 through which the anode electrode 160 is exposed, an organic layer 180 formed on the anode electrode 160 in the opening 175, and a cathode electrode 190 formed on the glass substrate 100.

The OELD described above forms a gate line 10 and the capacitor lower electrode 127 when forming the gate electrode 125 and forms a data line 20, a power supply line 30, and a capacitor upper electrode 147 when forming the source and drain electrodes 141 and 145.

Since two signal lines exist on one layer, the power supply line 30 is patterned to be formed in a line shape. Thus, when a power supply voltage is supplied to a pixel via the power supply line 30, due to voltage drop caused by the power supply line formed in a line shape, the power supply voltage supplied to a pixel according to the arrangement position of the pixel becomes non-uniform. As a result, non-uniform brightness occurs and image quality is degraded.

In addition, when two adjacent signal lines are arranged on one layer, due to extraneous particles formed during fabrication, a short 90 between the data line 20 and the power supply line 30 can occur, as shown in FIG. 1.

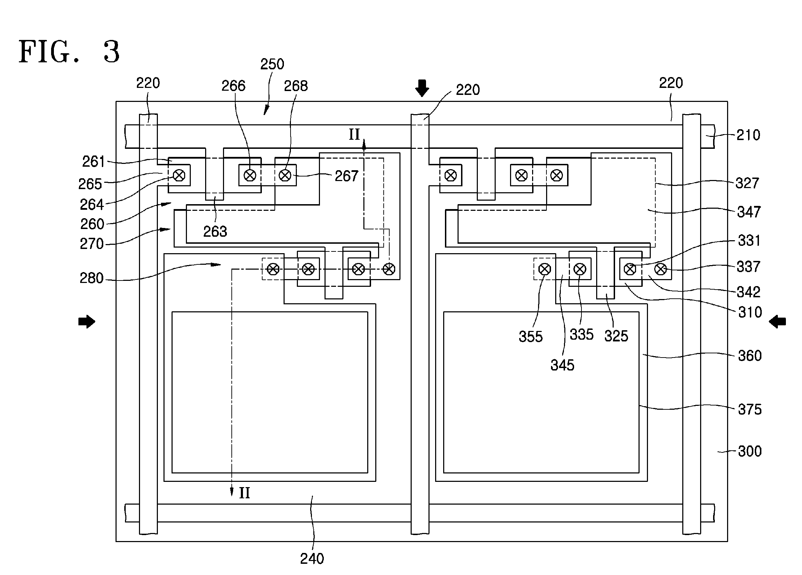

FIG. 3 is a plan view of a flexible OELD according to an embodiment of the present invention. The OELD of FIG. 3 includes a flexible substrate 300 formed of metal foil. A gate line 210 and a data line 220 are arranged on the substrate 300, and a pixel 250 is arranged in a pixel region 240 defined by the gate line 210 and the data line 220. The pixel 250 includes a switching TFT 260, a capacitor 270, a driving TFT 280, and an organic Electro-Luminescent (EL) element having a pixel electrode 360.

The switching TFT 260 includes a semiconductor layer 261 having source and drain regions (not shown), a gate electrode 263 connected to the gate line 210, and source and drain electrodes 265 and 267 each being respectively connected to the source and drain regions of the semiconductor layer 261 via contact holes 264 and 266. The source electrode 265 is connected to the data line 220.

The capacitor 270 includes a lower electrode 327 connected to the drain electrode 267 of the switching TFT 260 via a contact hole 268 and an upper electrode 347 formed above the lower electrode 327.

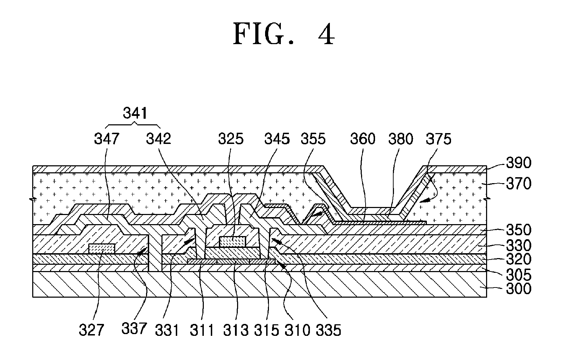

The driving TFT 280 includes a semiconductor layer 310 in which source and drain regions 311 and 315 shown in FIG. 4 are formed, a gate electrode 325 connected to the lower electrode 327 of the capacitor 270, and source and drain electrodes 342 and 345 that respectively electrically contact the source and drain regions 311 and 315 formed in the semiconductor layer 310 via contact holes 331 and 335. The source electrode 342 is connected to the upper electrode 347 of the capacitor 270.

The organic EL element includes an anode electrode 360 which is a pixel electrode connected to the drain electrode 345 of the driving TFT 280 through a via hole 355, an organic layer 380 formed on the anode electrode 360 exposed via an opening 375, and a cathode electrode 390 formed on the substrate 300 shown in FIG. 4.

In an embodiment of the present invention, a switching TFT (TFT) and/or a driving TFT include and/or includes a polysilicon TFT using a polysilicon layer as a semiconductor layer. However, the present invention is not limited thereto and the switching TFT and/or the driving TFT can include an organic TFT using an organic semiconductor layer as a semiconductor layer.

FIG. 4 is is a cross-sectional view of the OELD of FIG. 3 and taken along line II-II of FIG. 3. FIG. 4 shows only the driving TFT 280, the capacitor 270, and the EL element. A method of fabricating an OELD according to an embodiment of the present invention is described below with reference to FIG. 4.

First, a first insulating layer 305 is formed at one side of the substrate 300 formed of metal foil. The first insulating layer 305 includes a buffer layer. A polysilicon layer is formed on the buffer layer 305 and then is patterned, thereby forming the semiconductor layer 310 of the driving TFT 280. An amorphous silicon layer instead of the polysilicon layer can be used as the semiconductor layer 310.

A gate insulating layer 320 is formed as a second insulating layer on the substrate 300 and a gate electrode material is deposited on the gate insulating layer 320 and then is patterned, thereby forming a gate electrode 325 above the semiconductor layer 310 and the lower electrode 327 of the capacitor 270 to be spaced by apart from the gate electrode 325. A predetermined conductivity type of impurities, for example, p-type conductivity impurities, are implanted into the semiconductor layer 310, thereby forming the source and drain regions 311 and 315 in the semiconductor layer 310.

An Inter-Level Dielectric (ILD) layer 330 is formed as a third insulating layer on the substrate 300 and the gate insulating layer 320 and the ILD layer 330 are etched, thereby forming contact holes 331 and 335 that expose a part of the source and drain regions 311 and 315. When forming the contact holes 331 and 335, the ILD layer 330, the gate insulating layer 320, and the buffer layer 310 are etched, thereby forming a contact hole 337 through which a part of the substrate 300 is exposed.

A source and drain electrode material is deposited on the substrate 300 and then is patterned, thereby forming the source and drain electrodes 342 and 345 connected to the source and drain regions 311 and 315 of the semiconductor layer 310 via the contact holes 331 and 335. When the source and drain electrodes 342 and 345 are formed, the upper electrode 347 of the capacitor 270 that extends from the source electrode 342 is formed on the lower electrode 327.

A conductive pattern 341 is formed in an island shape, as shown in FIG. 3. The conductive pattern 341 acts as the source electrode 342 of the driving TFT 280 and the upper electrode 347 of the capacitor 270. Since the conductive pattern 341 electrically contacts the substrate 300 via the contact hole 337, a power supply voltage is supplied to the driving TFT 280 and the capacitor 270 from the substrate 300.

A protective layer 350 is deposited as a fourth insulating layer on the substrate 300 and the via hole 355 is then formed, the via hole 355 being the aperture through which one of the source and drain electrodes 342 and 345, for example, a part of the drain electrode 345, is exposed. A pixel electrode material is deposited on the substrate 300 and then is patterned, thereby forming the anode electrode 360, which is a pixel electrode, connected to the drain electrode 345 through the via hole 355.

A pixel isolation layer 370 is formed as a fifth insulating layer on the substrate 300 and the opening 375 through which a part of the pixel electrode 360 is exposed is then formed. In order to prevent a malfunction of a TFT caused by a voltage supplied to the substrate 300 and to prevent parasitic capacitance, the thickness of the pixel isolation layer 370 should be equal to or greater than 0.5 µ*m*. An organic layer 380 is formed on the anode electrode 360 in the opening 375, and the cathode electrode 390 is formed on the entire surface of the substrate 300.

The organic layer 380 is at least one layer selected from an Electron Injection Layer (EIL), an Electron Transport Layer (ETL), an EMission Layer (EML), a Hole Transport Layer (HTL), a Hole Injection Layer (HIL), and a Hole Blocking Layer (HBL). In an embodiment of the present invention, the organic layer 380 is formed in the opening 375 of the pixel isolation layer 370. However, the present invention is not limited to this, and a common layer, such as a charge transport layer formed above or below an EML, can be formed on the entire surface of the substrate 300.

Since the OELD according to an embodiment of the present invention has a front emission structure, the anode electrode 360 includes a transparent electrode having a reflection layer and the cathode electrode 390 includes a transmission electrode. In the OELD described above, since a substrate formed of metal foil acts as a power supply layer, as shown in FIG. 3, a power supply voltage is supplied to each pixel via a power supply layer formed in the shape of an electrode formed on the entire surface of the substrate. Thus, compared to a conventional OELD for supplying a power supply voltage to each pixel via a power supply line formed in a line shape, in the OELD for supplying a power supply voltage to each pixel via a substrate having the shape of the electrode formed on the entire surface of the substrate, according to the present invention, as indicated by arrow in FIG. 3, a power supply voltage is supplied to each pixel in all directions so that voltage drop can be minimized and a non-uniformity of voltage caused by voltage drops in the power supply line can be prevented by varying the arrangement position of each pixel.

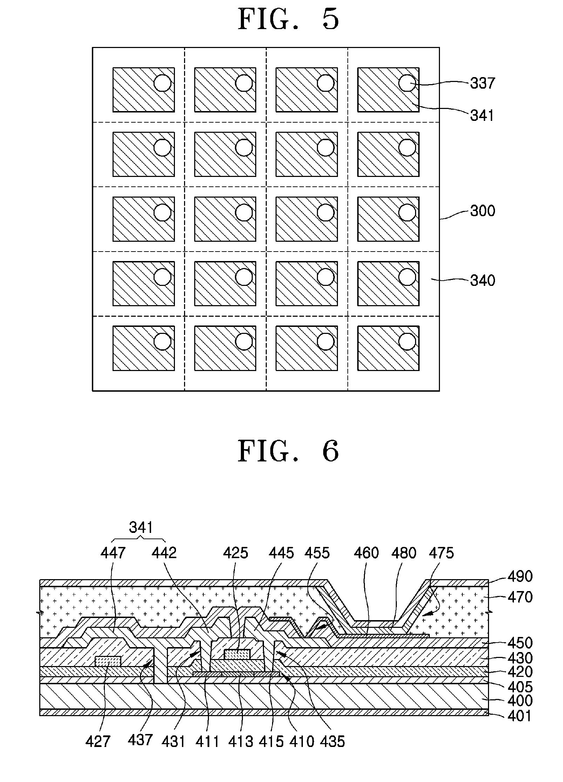

FIG. 5 is a view of the relationship of a substrate to source and drain electrodes of the OELD of FIG. 3. Referring to FIG. 5, the substrate 300 formed of metal foil includes a plurality of pixel regions 240 and a plurality of contact holes 337 through which a part of the pixel regions 240 is respectively exposed. A plurality of conductive patterns 341 are formed in an island shape in the pixel regions 240, respectively, and the conductive patterns 341 are electrically connected to the substrate 300 via the contact hole 337.

The conductive patterns 341 act as the upper electrode 347 of the capacitor 270 and one of the source and drain electrodes 342 and 345 of the driving TFT 280 connected to the upper electrode 347 of the capacitor 270, for example, a source electrode, as shown in FIG. 4. Since a power supply voltage is supplied to the conductive patterns 341 formed in an island shape from the substrate 300, the power supply voltage is supplied to the capacitor 170 and the driving TFT 280.

FIG. 6 is a cross-sectional view of an OELD according to another embodiment of the present invention. FIG. 6 shows only cross-sectional structures of an OELD element, a capacitor, and a driving TFT, taken along line II-II of FIG. 3. The OELD of FIG. 6 has the same structure as that of the OELD of FIG. 3. There is only one difference between FIG. 3 and FIG. 6 in that in FIG. 6, an insulating layer for insulating a substrate to be used as a power supply layer is formed on the other side of a substrate.

The OELD of FIG. 6 includes a flexible substrate 400 formed of metal foil. A buffer layer 405 is formed as a first insulating layer at one side of the substrate 400, and a semiconductor layer 410 of a driving TFT 280 is formed on the buffer layer 405. The semiconductor layer 410 includes source and drain regions 411 and 415 having a predetermined conductivity type, for example, p-type doped impurities.

A gate insulating layer 420 is formed as a second insulating layer on the substrate 400, a gate electrode 425 is formed above the semiconductor layer 410 of the gate insulating layer 420, and a lower electrode 427 of a capacitor 270 is formed to be spaced apart from the gate electrode 425.

An InterLevel Dielectric (ILD) layer 430 is formed as a third insulating layer on the substrate 400. Contact holes 431 and 435 through which a part of the source and drain regions 411 and 415 is exposed are formed in the gate insulating layer 420 and the ILD layer 430. In addition, a contact hole 437 through which a part of the substrate 400 is exposed is formed in the ILD layer 430, the gate insulating layer 420, and the buffer layer 405.

Source and drain electrodes 442 and 445 that electrically contact the source and drain regions 411 and 415 of the semiconductor layer 410 through the contact holes 431 and 435 are formed on the ILD layer 430, and an upper electrode 447 of the capacitor 270 that extends from one of the source and drain electrodes 442 and 445, for example, the source electrode 442.

A conductive pattern 341 that forms one of the source and drain electrodes 442 and 445 of the driving TFT 280, that is, the source electrode 442, and the upper electrode 447 of the capacitor 270 electrically contacts the substrate 400 formed of metal foil through the contact hole 437. Since a power supply voltage is supplied to the conductive pattern 341 from the substrate 400, the power supply voltage is supplied to the source electrode 442 of the driving TFT 280 and the upper electrode 447 of the capacitor 270.

A protective layer 450 is formed as a fourth insulating layer on the substrate 400. The protective layer 450 includes a via hole 455 through which a part of the source and drain electrodes 442 and 445 of the driving TFT 280, that is, a part of the drain electrode 445 is exposed.

An anode electrode 460 which is a pixel electrode connected to the drain electrode 445 of the driving TFT 280 through the via hole 455 is formed on the protective layer 450. A pixel isolation layer 470 having an opening 475 through which a part of the anode electrode 460 is exposed is formed on the substrate 400.

In order to prevent a malfunction of the driving TFT 270 formed on the buffer layer 405 and to prevent parasitic capacitance, the thickness and material of an insulating layer, such as the pixel isolation layer 470 and the buffer layer 405, should be properly selected. In particular, the thickness of the pixel isolation layer 470 should be equal to or greater than 0.5 µ*m* in consideration of the parasitic capacitance with the substrate 400 to be used as a power supply layer.

An organic layer 480 is formed on the anode electrode 460 in the opening 475, and a cathode electrode 490 is formed on the entire surface of the substrate 400. The organic layer 480 is a layer selected from an Electron Injection Layer (EIL), an Electron Transport Layer (ETL), an EMission Layer (EML), a Hole Transport Layer (HTL), a Hole Injection Layer (HIL), and a Hole Blocking Layer (HBL).

In addition, the OELD of FIG. 6 further includes an insulating layer 401 that is formed at the other side of the substrate 400 and insulates the substrate 400 to be used as a power supply layer.

Since the OELD of FIG. 6 has a front emission structure, the anode electrode 460 includes a transparent electrode having a reflection layer and the cathode electrode 490 includes a transmission electrode.

A flat panel display device using a TFT as a switching element for driving a pixel electrode of a display element and using a flexible substrate formed of metal foil as a substrate according to the present invention can be applied to any structure in which the substrate is used as a power supply layer.

According to the present invention, the pixel of the OELD according to the present invention includes an organic ElectroLuminescence (EL) element having one switching TFT, one driving TFT, and a capacitor. However, the present invention is not limited to this arrangement and the pixel of the OELD according to the present invention can be applied to pixels having a variety of structures.

The embodiments of the present invention are not limited to the OELD having the cross-sectional structure of FIGS. 4 or 6 and can be applied to an OELD having a variety of structures.

As described above, in the flat panel display device and its method of fabrication according to the present invention, a substrate formed of metal foil is used as a power supply layer such that voltage drops can be prevented and the uniformity of a TFT can be improved. In addition, the substrate is connected to source and drain electrodes of the TFT without the need of an additional process so as to be used as the power supply layer such that the entire process can be simplified.

In addition, the substrate formed of metal foil is used as the power supply layer such that shorts can be prevented from occurring in adjacent lines due to particles formed during processing and the yield and reliability of an element can be improved.

While the present invention has been particularly shown and described with reference to exemplary embodiments thereof, it will be understood by those of ordinary skill in the art that various modifications in form and detail can be made therein without departing from the spirit and scope of the present invention as defined by the following claims.

## Claims

1. A flat panel display device, comprising:
a conductive substrate (300);
a first insulating layer (305) arranged on one side of the conductive substrate (300) and having a contact hole (337) exposing a part of the substrate (300);
a Thin Film Transistor (280) having a semiconductor layer (310) arranged on the first insulating layer (305), a gate electrode (325), and source and drain electrodes (342, 345); and
a display element having a pixel electrode (360) connected to one of the source and drain electrodes (342, 345) of the Thin Film Transistor (280);
wherein the other of the source and drain electrodes (342, 345) of the Thin Film Transistor (280)is electrically connected to the conductive substrate (300) via the contact hole (337).

2. The flat panel display device of claim 1, comprising:
a plurality of pixel regions (240) being arranged on the conductive substrate (300); wherein the first insulating layer (305) is on the conductive substrate (300) and comprises a plurality of contact holes (337) respectively exposing parts of the pixel regions (240); and a plurality of Thin Film Transistors (280) is arranged on the first insulating layer (305) in each of the pixel regions (240), each of the Thin Film Transistors (280) having island shaped source and drain electrodes (342, 345); wherein a display element is arranged on the first insulating layer (305) in each of the pixel regions (240) and having a pixel electrode (360) connected to one of the source and drain electrodes (342, 345) of the Thin Film Transistors (280);
wherein the conductive substrate (300) is connected to the other of the source and drain electrodes (342, 345) of each of the Thin Film Transistors (280) via each of the contact holes (337) and is adapted to operate as a power supply layer to supply a power supply voltage to the Thin Film Transistors (280).

3. The flat panel display device of claim 1 or 2, wherein the conductive substrate (300) comprises a flexible substrate of a metal foil.

4. The flat panel display device of claim 1 or 2, wherein the first insulating layer comprises a buffer layer.

5. The flat panel display device of claim 1 or 2, wherein the display element comprises an organic electroluminescent element, the organic electroluminescent element including:
a lower electrode being the pixel electrode;
a second insulating layer having an opening exposing a part of the lower electrode;
an organic layer arranged on the lower electrode in the opening; and
an upper electrode arranged on the conductive substrate.

6. The flat panel display device of claim 5, wherein a thickness of the second insulating layer is equal to or greater than 0.5 *µm*.

7. The flat panel display device of claim 1 or 2, further comprising a third insulating layer arranged the other side of the conductive substrate to insulate the other side of the conductive substrate.

8. The flat panel display device of claim 1, wherein the TFT comprises a silicon TFT having a semiconductor layer of a silicon film or wherein the TFT comprises an organic TFT having an organic semiconductor layer.

9. A method of fabricating a flat panel display device, the method comprising:
forming a first insulating layer on a conductive substrate;
forming a semiconductor layer having source and drain regions and a gate electrode on the first insulating layer;
forming a second insulating layer on the conductive substrate;
etching the first insulating layer and the second insulating layer to form a first contact hole exposing parts of the source and drain regions of the semiconductor layer and a second contact hole exposing a part of the conductive substrate;
forming source and drain electrodes to contact each of the source and drain regions of the semiconductor layer via the first contact hole; and
forming a display element having a pixel electrode connected to one of the source and drain electrodes;
wherein the other of the source and drain electrodes is electrically connected to the conductive substrate via the contact hole.

10. The method of claim 9, wherein the conductive substrate comprises a flexible substrate formed of a metal foil.

11. The method of claim 9, wherein forming the first insulating layer comprises forming a buffer layer and forming the second insulating layer comprises forming an InterLevel Dielectric (ILD) layer.

12. The method of claim 9, wherein forming the display element comprises:
forming a lower electrode being the pixel electrode;
forming a third insulating layer having an opening exposing a part of the lower electrode;
forming an organic layer on the lower electrode in the opening; and
forming an upper electrode on the conductive substrate.

13. The method of claim 12, wherein a thickness of the third insulating layer is formed to be equal to or greater than 0.5 *µm*.

14. The method of claim 12, further comprising forming a fourth insulating layer on the other side of the conductive substrate to insulate the other side of the conductive substrate.
